# EUROPÄISCHE PATENTSCHRIFT

(11) **EP 2 748 686 B1**
(45) Veröffentlichungstag und Bekanntmachung des Hinweises auf die Patenterteilung: **24.06.2015**
(21) Anmeldenummer: 12743107.0
(22) Anmeldetag: 19.07.2012
(51) Int. Cl.: G05B 17/00, G06N 7/00, G06F 17/50, G05B 13/04

(54) **VERFAHREN ZUM ERSTELLEN EINER FUNKTION FÜR EIN STEUERGERÄT**
METHOD FOR THE CREATION OF A FUNCTION FOR A CONTROL DEVICE
PROCÉDÉ DE PRODUCTION D'UNE FONCTION POUR UN APPAREIL DE COMMANDE

(30) Priorität: 22.08.2011 DE 102011081346
(43) Veröffentlichungstag der Anmeldung: 02.07.2014
(60) Teilanmeldung: 14191618.9
(73) Patentinhaber: Robert Bosch GmbH, 70442 Stuttgart (DE)
(72) Erfinder: STREICHERT, Felix, Yokohoma-Shi Kanagawa 224-8501 (JP); MARKERT, Heiner, 70178 Stuttgart (DE); KRUSE, Thomas, 70190 Stuttgart (DE); IMHOF, Volker, 70806 Kornwestheim (DE); HUBEr, Thorsten, 70839 Gerlingen (DE); ULMER, Holger, 89077 Ulm (DE); DIENER, Rene, 71634 Ludwigsburg (DE); ANGERMAIER, Stefan, 70806 Kornwestheim (DE); KLOPPENBURG, Ernst, 71254 Ditzingen (DE)
(86) Internationale Anmeldenummer: PCT/EP2012/064147
(87) Internationale Veröffentlichungsnummer: WO 2013/026635

(56) Entgegenhaltungen:
- WO-A1-2006/051039
- KR-A- 20090 001 148

## Beschreibung

Die Erfindung betrifft ein Verfahren zum Erstellen einer Funktion für ein Steuergerät, insbesondere für ein Motorsteuergerät in einem Kraftfahrzeug, und eine Anordnung zur Durchführung des Verfahrens.

### Stand der Technik

Steuergeräte sind elektronische Module, die in Kraftfahrzeugen eingesetzt werden, um Abläufe zu steuern und/oder zu regeln. Hierzu sind in dem Steuergerät Funktionen implementiert, die in der Regel in Software realisiert sind und auf einem Prozessor bzw. einer CPU in dem Steuergerät zur Ausführung kommen. Unter der Applikation von Steuergeräten ist die Bedatung der Steuergeräte zu verstehen. Bedatung bedeutet dabei das Eingeben oder Aufspielen von Daten auf einer datenhaltenden Instanz, üblicherweise einer Speichereinrichtung in dem Steuergerät.

Ein Arbeitsschritt bei der Applikation von Motorsteuergeräten ist die sogenannte Grundanpassung. Bei der Grundanpassung werden bspw. Motorsteuerungs-Funktionen für die Erfassung der Zylinderfüllung bedatet. Hierbei werden Werkzeuge bzw. Tools zur Optimierung aller Bezeichner bzw. Labels einer solchen Funktion verwendet.

Als Eingabe in diese Werkzeuge werden sehr viele Messungen, die üblicherweise an einem Motorprüfstand ermittelt werden, benötigt, bei denen außer den Grundeinflussgrößen Drehzahl und Last weitere Einflussgrößen entsprechend den vorhandenen Füllungsstellern, wie Nockenwellenwinkelstellungen (Einlassund Auslassnockenwelle), Abgasrückführraten, Saugrohrumschaltungen, Ladungsbewegungsklappenstellungen usw., variiert werden müssen. Stand der Technik sind Methoden des "Design of Experiments" (DoE), die statt einer Rastervermessung aller zu variierender Einflussgrößen eine bestimmte Auswahl notwendiger Messungen pro Betriebspunkt, definiert durch Drehzahl und Last, vorschlagen, um daraus ein lokales Betriebspunktmodell, etwa ein Polynommodell (Cornerstone), anzupassen. Diese Modelle können dann nur an den Betriebspunkten, nicht jedoch dazwischen abgefragt werden.

Für die Bedatung der Labels einer Funktion, wie bspw. der Füllungserfassung, werden Messungen über den gesamten Betriebsbereich in ausreichender Genauigkeit benötigt. Um die Anzahl der Messungen dennoch gering zu halten, wird zwischen Messungen am Prüfstand und dem Optimierungstool ein sogenanntes globales datenbasiertes Modell eingeschoben. Auf diesem Modell werden dann virtuelle Messungen mit beliebigen Variationen der Einflussgrößen durchgeführt.

Aus der Druckschrift WO 2006/051039 A1 ist ein Verfahren zur Entwicklung eines globalen Modells einer Ausgangsgröße für ein dynamisches System bekannt. Dies kann bspw. ein Betriebsparameter einer Brennkraftmaschine sein. Dieses Verfahren soll es ermöglichen, mit wenigen Messpunkten auszukommen, um die Ausgangsgröße für alle Zustände zu berechnen. Bei der Entwicklung des globalen Modells erfolgt eine Entwicklung der Eingangsgröße mit Polynomen sowie eine Berechnung von Koeffizienten der Entwicklung. In der Druckschrift ist weiterhin beschrieben, Varianzen an Messstellen durch Wiederholungsmessungen zu ermitteln. Aus diesen Varianzen wird parallel zum Modell der Daten ein zweites Modell der Varianzen erstellt. Damit lässt sich beschreiben, in welchen Bereichen die Messungen genauer und in welchen Bereichen die Messungen ungenauer sind.

### Offenbarung der Erfindung

Vor diesem Hintergrund werden ein Verfahren zum Bedaten einer Funktion für ein Steuergerät gemäß Anspruch 1 und eine Anordnung zur Durchführung des Verfahrens mit den Merkmalen des Anspruchs 10 vorgestellt.

Die Erstellung des globalen datenbasierten Modells bietet den Vorteil, mit wesentlich weniger Messungen als einer Rastervermessung über alle Einflussgrößen das Verhalten des Motors mit der benötigten Genauigkeit darstellen zu können. Es werden auch weniger Messungen als für mehrere lokale Betriebspunktmodelle benötigt, da das globale Modell von den Messungen benachbarter Betriebspunkte ebenfalls "lernen" kann. Durch die Reduktion der Anzahl der Messpunkte werden insbesondere zukünftige Applikationsaufgaben mit steigender Zahl von Einflussgrößen erst durch die Verringerung der Messzeit realisierbar und beherrschbar.

Das globale datenbasierte Modell liefert dabei für jede gewünschte Drehzahl und Lastposition einen Wert für die Zielgrößen, nicht nur an den vermessenen Betriebspunkten. Auf Grundlage der Modellunsicherheit kann die Modellgüte des globalen datenbasierten Modells geprüft und bewertet werden, bevor mit dem nächsten Schritt der Optimierung fortgefahren wird. Es wird dabei festgestellt, ob die Anzahl der Messungen und die Variation der Stellerpositionen ausreichend waren. Ebenfalls können Messausreißer leicht identifiziert werden.

Das globale datenbasierte Modell benötigt außer der Vorhersage der Zielgrößen, wie bspw. Füllung, Verbrauch oder Emissionen, auch die Fähigkeit, eine Modellunsicherheit (Sigma) für jede eingestellte Variation von Einflussgrößen berechnen zu können. Ein Beispiel für datenbasierte Modelle, welche die Modellunsicherheit angeben, sind die sogenannten Bayesschen Regressionsverfahren wie Kriging ("A statistical approach to some mine valuations and allied problems at the Witwatersrand", D.G. Krige, 1951; "The intrinsic random functions, and their applications", G. Matheron, Adv. Appl. Prob., 5, pp 439-468, 1973), Gaussian Process Models ("Gaussian Processes for Machine Learning", Rasmussen and Williams, MIT Press, 2006), Sparse Gaussian Processes ("Sparse Gaussian processes using pseudo-inputs"; E. Snelson and Z Ghahramani, Advances in Neural Information Processing Systems 18, pp 1259-1266, 2006) und viele andere. Eine weitere Möglichkeit für datenbasierte Modelle mit Modellunsicherheit sind Komitees von Neuronalen Netzen ("Validation of Neural Networks in Automotive Engine Calibration", D. Lowe and K. Zapart, 1997).

Das globale datenbasierte Modell muss darüber hinaus in der Lage sein, mit dem Messrauschen der Prüfstandsmessung umzugehen, d. h. es wird in Ausgestaltung keine Interpolation durch jeden Messwert, sondern eine bspw. glatte Regression zwischen den Messpunkten durchgeführt.

Weiterhin ist zu beachten, dass anhand des datenbasierten Modells das Verhalten des vermessenen Systems über die Variation der Eingangsgrößen visualisiert werden kann, was zu einem größeren Systemverständnis und damit zu besserer Qualität der Bedatung führt.

Wenn das globale datenbasierte Modell die erforderliche Güte erbringt, kann dieses Modell dazu verwendet werden, an den für die Optimierung notwendigen Stellen virtuelle Messungen durchzuführen. Die Anzahl dieser Messungen kann die Anzahl der zur Bildung des Modells notwendigen Messungen bei weitem übersteigen, da hierfür kein Motorprüfstand mehr benötigt wird.

Anhand der Angabe der Modellunsicherheit Sigma kann bei jedem virtuellen Messpunkt entschieden werden, ob dieser für die nachfolgende Optimierung verwendet werden soll oder nicht. Damit wird vermieden, dass der Optimierer unnötig versucht, ungültige Messwerte anzupassen, was vergleichbar mit nicht identifizierten Messausreißern ist.

Die virtuellen Messungen haben außerdem den Vorteil, dass sie kein Messrauschen mehr aufweisen und damit für die nachfolgende Optimierungsaufgabe wesentlich besser geeignet sind. Bei glatten Regressionsflächen bleiben die Optimierungsverfahren nicht in sogenannten lokalen Minima hängen, wie dies bei interpolierten Flächen eher der Fall ist.

Wenn sich in der zu bedatenden Steuergerätefunktion die Stützstellenpositionen und -anzahl der Label ändern, werden Messungen an weiteren Messpunkten notwendig. Wenn bspw. ein Kennfeld mit 3 x 3 Stützstellen auf 5 x 5 Stützstellen erweitert wird, können zwar die 25 Kennfeldwerte des größeren Kennfelds aus dem kleineren Kennfeld durch lineare Interpolation berechnet werden. Für die Ausnutzung der Variabilität dieses Kennfelds sind jedoch weitere Informationen der Zielgrößen des Motors notwendig. Ein Vorteil des vorgestellten Verfahrens besteht darin, dass die zusätzlichen Messpunkte nicht aufwendig am Prüfstand, sondern sofort am globalen datenbasierten Modell virtuell gemessen werden können.

Wenn ein bestimmter Motor in unterschiedlichen Fahrzeugvarianten eingebaut wird, müssen für jede Fahrzeugvariante die Steuergerätefunktionen in unterschiedlichen Betriebsbereichen optimiert werden. Hierfür sind jeweils andere Messpunkte für die Optimierung der Steuergerätefunktion notwendig. Bei dem beschriebenen Verfahren kann der Motor einmal umfassend für die Erstellung des globalen datenbasierten Modells vermessen werden. Die virtuellen Messpunktsätze für die unterschiedlichen Betriebsbereiche der verschiedenen Fahrzeugvarianten können dann an einem globalen datenbasierten Modell gemessen werden.

Im Rahmen des vorgestellten Verfahrens kann zum einen die Güte des globalen datenbasierten Modells anhand von Testpunkten geprüft werden oder anhand der Unsicherheiten bzw. Varianzen der virtuellen Messergebnisse kann festgestellt werden, dass die Güte des Modells insgesamt oder in gewissen Bereichen nicht ausreichend ist. Verbesserungen des datenbasierten Modells können auf Basis ergänzender Messwerte aus ergänzenden Messungen am Prüfstand vorgenommen werden, wenn die Güte des globalen datenbasierten Modells zumindest in dem einen Bereich der Messpunkte unzureichend ist. Zum anderen kann bei der Bedatung und damit Erstellung der Steuergerätefunktion die Unsicherheit der einzelnen virtuellen Messpunkte berücksichtigt werden. Hierzu kann vorgesehen sein, dass für jeden Messwert eine Unsicherheit ermittelt wird. Anhand der Unsicherheit des virtuellen Messwerts, wobei mindestens einer der Messwerte herangezogen werden kann, kann entschieden werden, ob dieser für das Bedaten der Funktion verwendet wird.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen
- Figur 1: zeigt ein Verfahren gemäß dem Stand der Technik.
- Figur 2: zeigt ein Verfahren gemäß der vorliegenden Erfindung.
- Figur 3: zeigt die Verwendung eines globalen datenbasierten Modells.
- Figur 4: zeigt in einem Graphen Messwerte, die bei unterschiedlichen Messpunkten aufgetragen sind.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

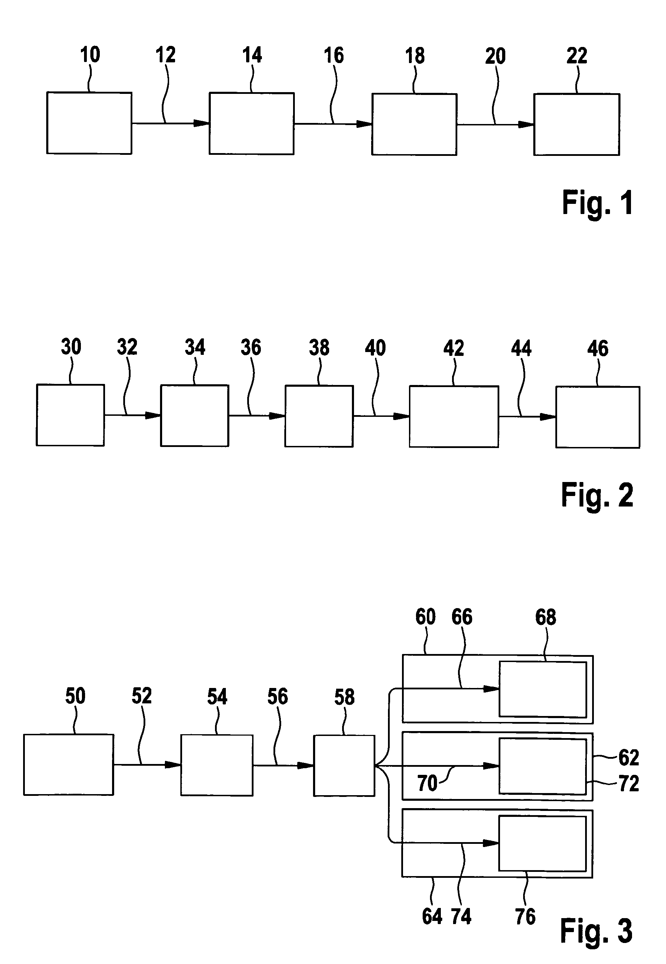

In Figur 1 ist in einem Diagramm die bisherige Vorgehensweise bei der Bedatung einer Steuergerätefunktion dargestellt. Es erfolgt eine Versuchsplanung mit einer Methode des DoE 10. Dabei erfolgt eine Rastervermessung aller zu variierenden Einflussgrößen zur Erlangung von Eingangsgrößen (Pfeil 12) für Prüfstandsmessungen 14. Die Prüfstandsmessungen 14 ergeben Messwerte mit Messrauschen, die in ein Werkzeug 18 eingegeben werden (Pfeil 16), in dem eine Optimierung der Labels der Funktion durchgeführt wird. Mit den optimierten Label der Funktion (Pfeil 20) ergibt sich dann die bedatete Steuergerätefunktion 22.

Für die zu bedatende Steuergerätefunktion wird somit gemäß dem Stand der Technik ein geeigneter Versuchsplan für die Messungen festgelegt. Diese Messungen werden am Motorprüfstand möglichst genau eingestellt und die Zielgrößen wie Füllung, Verbrauch oder Emissionen gemessen. Diese Messwerte werden für die Optimierung der Labelwerte einer Funktion verwendet. Das Ergebnis ist eine bedatete Funktion, die in einem Motorsteuergerät verwendet werden kann.

In Figur 2 ist die Verwendung eines globalen datenbasierten Modells zur Bedatung einer Funktion für ein Steuergerät dargestellt, bei der zwischen einer Prüfstandsmessung und einer Optimierung ein globales datenbasiertes Modell eingefügt wird. Es erfolgt hierbei eine Versuchsplanung mit einer Methode des DoE 30. Mittels Variation von Einflussgrößen werden Eingangsgrößen (Pfeil 32) für Prüfstandsmessungen 34 ermittelt. Bei den Prüfstandsmessungen 34 ergeben sich Messwerte mit Messrauschen, mit denen (Pfeil 36) ein globales datenbasiertes Modell 38 erstellt bzw. trainiert wird.

Auf bzw. an diesem globalen datenbasierten Modell 38 werden virtuelle Messungen durchgeführt, die reelle Messungen an dem Prüfstand simulieren. Daraus ergeben sich Messwerte ohne Rauschen (Pfeil 40), die in ein Werkzeug 42 eingegeben werden, in dem eine Optimierung der Labels einer Funktion durchgeführt wird. Mit den optimierten Label der Funktion (Pfeil 44) ergibt sich dann die bedatete Steuergerätefunktion 46.

Bei dem hierin vorgestellten Verfahren in Figur 2 wird nach der Prüfstandsmessung 34 das globale datenbasierte Modell 38 eingefügt. Dieses wird anhand der Messungen vom Prüfstand mit Trainingspunkten trainiert und die Güte anhand von Testpunkten verifiziert. Als Modelltyp können dafür ASC-Modelle in einem Modellierungstool verwendet werden. Andere Modelltypen wie neuronale Netze oder Support Vector Regression sind denkbare Alternativen, benötigen jedoch zusätzlich eine adäquate Berechnung der Modellunsicherheit Sigma. Mit solchen Modellen können auch Messausreißer vom Prüfstand identifiziert werden und entweder ignoriert oder nachgemessen werden. Der Schritt der Modellbildung ist abgeschlossen, wenn das globale datenbasierte Modell die für die Anwendung notwendige Güte aufweist.

Anhand des globalen datenbasierten Modells werden virtuelle Messungen simuliert, die für die Optimierung der Labels besser geeignet sind. Dies kann auch in einem Tool realisiert werden, bei dem ein datenbasiertes Modell an vorgegebenen Messpunkten abgefragt wird. Diese virtuellen Messungen unterliegen jetzt keinem Messrauschen mehr, da eine wiederholte Abfrage an der gleichen Stelle auch den gleichen Messwert ergibt. Von den angeforderten virtuellen Messpunkten können anhand der Modellunsicherheit diejenigen mit großem Sigma aussortiert werden.

Figur 3 zeigt die Verwendung eines Modells für die Bedatung unterschiedlicher Fahrzeugvarianten. Dabei erfolgt eine Versuchsplanung mit einer Methode des DoE 50. Mittels Variation von Einflussgrößen werden Eingangsgrößen (Pfeil 52) für Prüfstandsmessungen 54 ermittelt. Bei den Prüfstandsmessungen ergeben sich Messwerte mit Messrauschen, mit denen (Pfeil 56) ein globales datenbasiertes Modell 58 erstellt wird. Dieses globale datenbasierte Modell 58 wird für eine erste Fahrzeugvariante 60, eine zweite Fahrzeugvariante 62 und eine dritte Fahrzeugvariante 64 verwendet. Für die erste Fahrzeugvariante 60 ergeben sich virtuelle Messwerte in einem ersten Betriebsbereich (Pfeil 66), die in ein Werkzeug 68 zur Optimierung der Labels der Funktion eingegeben werden. Entsprechend ergeben sich für die zweite Fahrzeugvariante 62 virtuelle Messwerte eines zweiten Betriebsbereichs (Pfeil 70), die in ein Werkzeug 72 zur Optimierung der Labels der Funktion eingegeben werden. Schließlich ergeben sich für die dritte Fahrzeugvariante 64 virtuelle Messwerte eines dritten Betriebsbereichs (Pfeil 74), die in ein entsprechendes Werkzeug 76 zur Optimierung der Labels der Funktion eingegeben werden.

In Figur 3 wird somit die Verwendung eines gemeinsamen globalen datenbasierten Modells 58 für die Bedatung von Steuergerätefunktionen für verschiedene Fahrzeugvarianten dargestellt. Es stellt sich heraus, dass der Messbedarf am Prüfstand für die Abdeckung der Betriebsbereiche aller Fahrzeugvarianten nur unwesentlich steigt.

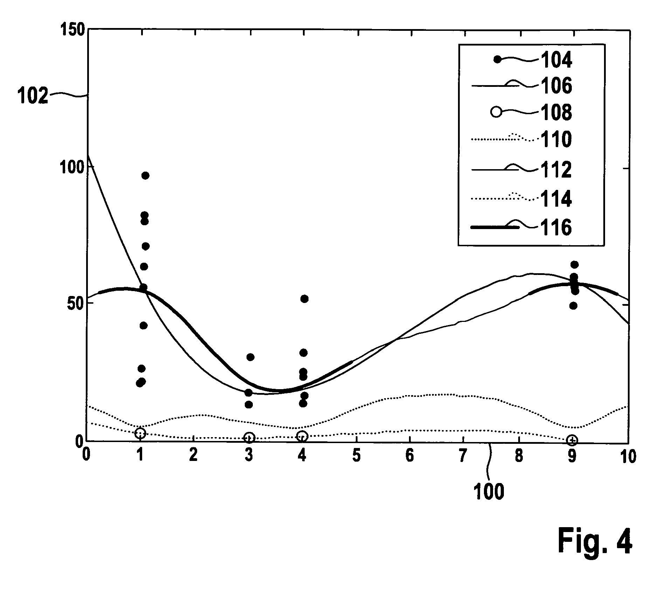

Figur 4 verdeutlicht in einem Graphen das eingesetzte Modellierungsverfahren, dabei sind an einer Abszisse 100 Messstellen bzw. Messpunkten X und an einer Ordinate 102 die Höhe der Messwerte aufgetragen. In dem Graphen sind eingetragen Messwerte bzw. Daten 104, ein Polynom 106 der Daten, ein Sigma 108 der Daten, ein Polynom 110 des Sigmas der Daten, das Bayessche Regressionsmodell 112 der Daten, ein Sigma 114 des Bayesschen Regressionsmodells, und eine Gültigkeit 116 des Bayesschen Regressionsmodells eingetragen.

In Figur 4 sind an vier Messpunkten jeweils zehn Messungen (bei x = 3 nur 5 Messungen) gemacht worden (Daten). Als Modell der Ausgangsgröße wurde ein einfaches Polynommodel dritter Ordnung gewählt, dessen Koeffizienten bestimmt wurden (Polynom der Daten). An den vier Messpunkten wurde die Varianz der Messung durch Wiederholungsmessungen bestimmt (Sigma der Daten) und aus diesen vier Werten wiederum ein Polynommodel dritter Ordnung erstellt (Polynom von Sigma der Daten). Man erkennt, dass die Varianz der Messdaten auf der linken Seite größer ist als in der Mitte. Auf der rechten Seite ist die Wiederholungsmessung recht genau.

Gemäß dem beschriebenen Verfahren wird eine Variante der Bayesschen Regressionsverfahren verwendet, z. B. die Gaußschen Prozessmodelle (gaussian process model of data). Es ist zu erkennen, dass beide Modelle an den Messpunkten vergleichbare Modellwerte berechnen. Zusätzlich zu der Modellvorhersage des Bayesschen Regressionsmodells wird noch eine Modellunsicherheit ausgegeben (Sigma des Bayesschen Regressionsmodells). Diese sagt aus, wie sicher sich das Modell bei seiner Vorhersage an einer bestimmten Eingangsposition ist. Man sieht, dass das Modell-Sigma an den vier Messstellen klein ist, denn an diesen Stellen stehen dem Modell Informationen zur Verfügung. Zwischen den Messstellen (z. B. von 5 bis 8) gibt das Modell zwar eine Modellvorhersage, ist sich aber wegen des größeren Modell-Sigma unsicher.

Diese Modellunsicherheit ist somit von der Position der Messpunkte und nicht von der Varianz der Messdaten an den Messpunkten abhängig. Das Sigma des Modells ist bei x = 1 gleich groß wie bei x = 9, obwohl die Varianz der Wiederholmessungen sehr unterschiedlich ist. Dennoch kann das Modell eine sehr genaue Aussage über den Mittelwert der Messung treffen. Bei x = 3 sind weniger Wiederholmessungen durchgeführt worden. Deshalb ist das Modell-Sigma gegenüber x = 4 etwas erhöht. Mit diesem Modell-Sigma kann geprüft werden, ob die Modellgüte im gesamten vermessenen Bereich ausreichend ist (Gültigkeit des Bayesschen Regressionsmodells).

Das Polynommodell über die Varianz der Messwerte, wie dies aus dem Stand der Technik bekannt ist, unterscheidet sich demnach grundlegend von der Beurteilung der Modellgüte mittels des Modell Sigma der Bayesschen Regressionsmodelle.

Es ist festzuhalten, dass bei dem vorgestellten Verfahren die Verwendung des Modell-Sigma zur Beurteilung der Modellgüte erstmalig erfolgt.

Die virtuellen Messungen sind einfach ein Abfragen des datenbasierten Modells an der gewünschten Eingangsposition (bspw. für x = 6). Wenn es die Optimierungsaufgabe erfordert, kann das Modell bspw. an den Stellen x = [0 2 4 6 8 10] abgefragt werden, obwohl die Messungen zur Erstellung des Modells nur bei x' = [1 3 4 9] erfolgt sind. Es erfolgt ein Abfragen eines datenbasierten Modells als virtuelle Messungen, insbesondere die Beurteilung, dass die Modellvorhersage für x = [6 8] zu ungenau ist, ist bislang nicht beschrieben.

In manchen Fällen werden in Steuergerätefunktionen die Stützstellen einzelner Kennlinien oder Kennfelder verändert, wenn bspw. das Stützstellenraster zu grob ist, bei Verknüpfung mit anderen Kennlinien oder Kennfeldern durch Gruppenstützstellen, usw. Wenn jetzt die Ausgangsgröße für x = [1 3 5 6 7 9] notwendig ist, kann dies wiederum am Modell erfolgen, unabhängig von den Messstellen zur Erstellung des Modells. Diese Kennlinien oder Kennfelder sind nicht mit dem globalen datenbasierten Modell zu verwechseln, sondern stellen optimierte Sollwerte der Eingangsgrößen dar.

Bei der Erstellung bzw. dem Training des datenbasierten Modells, bspw. eines Bayesschen Regressionsmodells, sind im Wesentlichen Messungen gemäß einem Versuchsplan (Design of Experiment - DoE) erforderlich. Dieser sollte jedoch andere Eigenschaften aufweisen als ein Versuchsplan für das Schätzen der Koeffizienten eines Polynoms. Wie aus Figur 4 zu erkennen ist, sollten die Messungen raumfüllend verteilt werden, damit das Bayessche Regressionsmodell überall gültig ist. Dafür sind keine Wiederholungsmessungen an einzelnen Messstellen notwendig.

Ein Beispiel eines einfachen globalen Modells über die Betriebspunkte Drehzahl, der weiteren Eingangsgröße Einspritzmenge und der Ausgangsgröße Verbrauch soll den Sachverhalt der Reduktion der notwendigen Messungen verdeutlichen.

Wird als globales Modell ein Kennfeld gewählt mit einem Raster von [6 x 5] Stützstellen, so sind mindestens 30 Messungen bei Variationen von Drehzahl und Einspritzmenge erforderlich, um die Kennfeldwerte für den Verbrauch zu erhalten.

Die erste Reduktion an Messungen wurde erzielt, indem entlang der Eingangsgröße Einspritzmenge quadratisches Verhalten angenommen wurde. Deshalb wurde für jeden Betriebspunkt (6 Stützstellen) ein Polynommodell erstellt, wofür mindestens 3 Messungen pro Betriebspunkt notwendig sind. Dies ergibt minimal 18 Messungen zur Erstellung von 6 Betriebspunktmodellen (vgl. Cornerstone). Bei diesen Modellen konnte keine Aussage für den Verbrauch getroffen werden, wenn eine Drehzahl zwischen den Stützstellen gefordert wurde.

Zur Erstellung eines globalen Gaußschen Prozessmodells für den Verbrauch über Drehzahl und Einspritzmenge sind ca. 15 raumfüllende Messungen notwendig, wenn die Verbrauchsfläche glatt ist.

In der Druckschrift WO 2006/051039 A1 werden 528 genau positionierte Messstellen zur Berechnung der Koeffizienten eines globalen Tschebyschew Polynoms der Ordnung 2-3-3-10 genannt. Für die Erstellung eines vergleichbaren Gaußschen Prozessmodells würden ca. 300 raumfüllende Messungen ausreichen.

In Figur 4 ist zu erkennen, dass die Messungen an den Messpunkten bedingt durch das Messprinzip bzw. die Messgeräte einem Messrauschen unterliegen. Werden die realen Messungen durch virtuellen Messungen am globalen datenbasierten Modell ersetzt, weisen diese kein Rauschen auf, da der Funktionswert an einer Stelle x immer den gleichen Wert y zurückliefert.

Das vorgestellte Verfahren stellt eine Applikationsmethode zur Parametrisierung der Steuergerätefunktionen für einen optimalen Betrieb, bspw. eines Motors, dar. Bei Änderung der Position oder der Anzahl der Stützstellen eines oder mehrerer Labels der Steuergerätefunktionen sowie bei der Bedatung der Steuergerätefunktionen für verschiedene Fahrzeugvarianten bei gleichem Motor sind dann keine weiteren Messungen an dem realen System, in diesem Fall dem Motor auf dem Prüfstand, notwendig.

## Patentansprüche

1. Verfahren zum Bedaten einer auf einem Steuergerät implementierten Funktion (46), bei dem Messungen (34, 54) an einem System bei unterschiedlichen Messpunkten an einem Prüfstand durchgeführt werden und anhand der erhaltenen Messwerte ein globales datenbasiertes Modell (38, 58) erstellt wird, wobei an dem globalen datenbasierten Modell (38, 58) virtuelle Messungen durchgeführt werden, die reelle Messungen an dem Prüfstand simulieren, wobei aus dem globalen datenbasierten Modell (38, 58) Unsicherheiten für virtuelle Messwerte der virtuellen Messungen ermittelt werden und die Unsicherheiten der virtuellen Messwerte beim Bedaten der Funktion (46) für, das Steuergerät berücksichtigt werden, **dadurch gekennzeichnet, dass** auf Basis der Unsicherheiten der virtuellen Messwerte erkannt wird, ob eine Güte des datenbasierten Modells (38, 58) zumindest in einem Bereich der Messpunkte unzureichend für das Bedaten der Funktion ist, und Verbesserungen des datenbasierten Modells (38, 58) auf Basis ergänzender Messwerte aus ergänzenden Messungen an dem Prüfstand, falls die Güte des datenbasierten Modells (38, 58) zumindest in dem einen Bereich der Messpunkte unzureichend ist, erreicht werden.

2. Verfahren nach Anspruch 1, bei dem für jeden virtuellen Messwert eine Unsicherheit ermittelt wird.

3. Verfahren nach Anspruch 1 oder 2, bei dem anhand der Unsicherheit mindestens eines der virtuellen Messwerte entschieden wird, ob dieser für das Bedaten der Funktion herangezogen wird.

4. Verfahren nach einem der Ansprüche 1 bis 3, bei dem als globales datenbasiertes Modell (38, 58) ein Bayessches Regressionsmodell verwendet wird.

5. Verfahren nach einem der Ansprüche 1 bis 3, bei dem als globales datenbasiertes Modell (38, 58) ein Gaußsches Prozessmodel verwendet wird.

6. Verfahren nach einem der Ansprüche 1 bis 5, bei dem eine glatte Regression zwischen den Messpunkten durchgeführt wird.

7. Verfahren nach einem der Ansprüche 1 bis 6, bei dem anhand des globalen datenbasierten Modells (38, 58) ein Verhalten des vermessenen Systems visualisiert wird.

8. Verfahren nach Anspruch 7, bei dem das Verhalten über eine Variation von Eingangsgrößen visualisiert wird.

## Claims

1. Method for inputting data to a function (46) implemented on a control device, in which measurements (34, 54) on a system are carried out at different measurement points on a test bench and a global data-based model (38, 58) is created using the measured values obtained, virtual measurements which simulate real measurements on the test bench being carried out on the global data-based model (38, 58), uncertainties for virtual measured values of the virtual measurements being determined from the global data-based model (38, 58) and the uncertainties of the virtual measured values being taken into account when inputting data to the function (46) for the control device, **characterized in that** it is detected, on the basis of the uncertainties of the virtual measured values, whether a quality of the data-based model (38, 58) is insufficient for inputting data to the function at least in one region of the measurement points, and improvements to the data-based model (38, 58) are achieved on the basis of supplementary measured values from supplementary measurements on the test bench if the quality of the data-based model (38, 58) is insufficient at least in the one region of the measurement points.

2. Method according to Claim 1, in which an uncertainty is determined for each virtual measured value.

3. Method according to Claim 1 or 2, in which the uncertainty of at least one of the virtual measured values is used to decide whether this measured value is used to input data to the function.

4. Method according to one of Claims 1 to 3, in which a Bayesian regression model is used as the global data-based model (38, 58).

5. Method according to one of Claims 1 to 3, in which a Gaussian process model is used as the global data-based model (38, 58).

6. Method according to one of Claims 1 to 5, in which a smooth regression is carried out between the measurement points.

7. Method according to one of Claims 1 to 6, in which a behaviour of the measured system is visualized using the global data-based model (38, 58).

8. Method according to Claim 7, in which the behaviour is visualized by varying input variables.

## Revendications

1. Procédé pour alimenter en données une fonction (46) mise en oeuvre sur une unité de commande, dans lequel des mesures (34, 54) sont effectuées sur un système en différents points de mesure sur un banc d'essai et un modèle global basé sur les données (38, 58) est créé sur la base des valeurs de mesure obtenues, dans lequel des mesures virtuelles sont effectuées sur le modèle global à base de données (38, 58), qui simulent des mesures réelles sur le banc d'essai, dans lequel des incertitudes sont calculées pour des valeurs de mesure virtuelles des mesures virtuelles à partir du modèle global basé sur les données (38, 58) et les incertitudes des valeurs de mesure virtuelles lors de l'alimentation en données de la fonction (46) pour le dispositif de commande sont prises en compte, **caractérisé en ce qu'**on détermine, sur la base des incertitudes des valeurs de mesure virtuelles si une qualité du modèle basé sur les données (38, 58) est insuffisante pour l'alimentation en données de la fonction dans au moins une région des points de mesure, et des améliorations du modèle la basé sur les données (38, 58) sont obtenues sur la base de valeurs de mesure complémentaires à partir de mesures complémentaires sur le banc d'essai, si la qualité du modèle basé sur les données (38, 58) est insuffisante au moins dans ladite la région des points de mesure.

2. Procédé selon la revendication 1, dans lequel une incertitude est déterminée pour chaque valeur de mesure virtuelle.

3. Procédé selon la revendication 1 ou 2, dans lequel, sur la base de l'incertitude d'au moins l'une des valeurs de mesure virtuelles, il est décidé si celle-ci est utilisée pour l'alimentation en données de la fonction.

4. Procédé selon l'une quelconque des revendications 1 à 3, dans lequel on utilise en tant que modèle global basé sur les données (38, 58) un modèle de régression bayésien.

5. Procédé selon l'une quelconque des revendications 1 à 3, dans lequel on utilise en tant que modèle global basé sur les données (38, 58) un modèle de processus gaussien.

6. Procédé selon l'une quelconque des revendications 1 à 5, dans lequel une régression de lissage est effectuée entre les points de mesure.

7. Procédé selon l'une quelconque des revendications 1 à 6, dans lequel on visualise un comportement du système mesuré sur la base du modèle global basé sur les données (38, 58).

8. Procédé selon la revendication 7, dans lequel le comportement est visualisé par l'intermédiaire d'une variation de grandeurs d'entrée.
